**Europäisches Patentamt**

**European Patent Office**

**Office européen des brevets**

(19)

(11) **EP 0 848 825 B1**

(12) **EUROPÄISCHE PATENTSCHRIFT**

(45) Veröffentlichungstag und Bekanntmachung des Hinweises auf die Patenterteilung:
**19.12.2001   Patentblatt 2001/51**

(51) Int Cl.⁷: **G01R 21/133**

(21) Anmeldenummer: **96937176.4**

(22) Anmeldetag: **03.09.1996**

(86) Internationale Anmeldenummer:
**PCT/DE96/01636**

(87) Internationale Veröffentlichungsnummer:
**WO 97/09626 (13.03.1997 Gazette 1997/12)**

(54) **ELEKTRIZITÄTSZÄHLER**

ELECTRICITY METER

COMPTEUR ELECTRIQUE

(84) Benannte Vertragsstaaten:
**BE DE ES FR GB IT NL SE**

(30) Priorität: **04.09.1995   DE 19532588**

(43) Veröffentlichungstag der Anmeldung:
**24.06.1998   Patentblatt 1998/26**

(73) Patentinhaber: **SIEMENS AKTIENGESELLSCHAFT**
**80333 München (DE)**

(72) Erfinder:
 • **HAEFELE, Günter**
 **D-91052 Erlangen (DE)**
 • **SCHWENDTNER, Manfred**
 **D-90592 Schwarzenbruck (DE)**
 • **FÖRTHNER, Rainer**
 **D-90592 Schwarzenbruck (DE)**
 • **WINDSHEIMER, Klaus**
 **D-91174 Spalt (DE)**

(56) Entgegenhaltungen:
**EP-A- 0 437 861        WO-A-91/19201**
**DE-U- 9 213 457        US-A- 4 992 725**
**US-A- 5 301 121**

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Elektrizitätszähler gemäß dem Oberbegriff des Patentanspruchs 1 (US 4,992,725).

Aus der DE-OS-37 27 053 ist ein Eingangsschaltkreis eines Elektrizitätszählers bekannt, bei dem einem differenzierenden Eingangswandler ein Integrator mit Gleichspannungsgegenkopplung nachgeschaltet ist. Der Integrator dient dazu, die differenzierende Wirkung des Eingangswandlers zu kompensieren. In diesem Beispiel ist der Integrator als Operationsverstärker mit einer RC-Beschaltung im Gegenkopplungszweig ausgeführt. Der Nachteil derartiger Schaltungen liegt in der Langzeitdrift und der Temperaturdrift des im Gegenkopplungszweig angeordneten Integrationskondensators. Zusätzlich stellen magnetische und elektrische Einkopplungen für den Integrator ein Problem dar.

Bei Ausführung des Zählers mit digitaler Signalverarbeitung besteht zudem das Problem, daß die dort verwendeten Bauteile sehr empfindlich gegen Störungen sind. Dies betrifft insbesondere Spannungsspitzen, wie sie zum Beispiel bei differenzierenden Wandlern auftreten.

Aus der US-PS 5,315,236 ist ein Elektrizitätszähler bekannt, der zum Anschluß an einen differenzierenden Eingangswandler bestimmt ist. Diesem ist ein Digital/Analogwandler und eine Einrichtung zur digitalen Signalverarbeitung nachgeschaltet. Zwischen Eingangswandler und Digital/Analogwandler ist ein analoges Filter geschaltet, welches als aktives Tiefpaßfilter mit Verstärker ausgebildet ist. Die als CPU ausgebildete Einrichtung zur digitalen Signalverarbeitung dient zur Errechnung des Stromverbrauchs aus den Eingangsdaten.

Aus der EP 0 634 662 A1 ist prinzipiell die Verwendung von Sigma-Delta-Wandlern und Multiplexern bei dreiphasigen Elektrizitätszählern bekannt.

Der Erfindung liegt die Aufgabe zugrunde, einen Elektrizitätszähler mit differenzierenden Eingangswandlern und digitaler Signalverarbeitung anzugeben, bei dem auf zuverlässige Art und Weise ein Abbild des gemessenen Signals erzeugt werden kann, ohne daß eine Signalverfälschung eintritt.

Die Lösung der Aufgabe gelingt erfindungsgemäß mit einem Elektrizitätszähler gemäß den Merkmalen des Anspruchs 1.

Durch die Filterfunktion des analogen Filters ist eine Begrenzung für Spannungsimpulse gegeben, die von dem Eingangswandler abgegeben werden. Die Veränderung des Eingangssignals ist jedoch definiert und wird nachfolgend in der Signalverarbeitung kompensiert. Auf diese Weise ist eine Integrierfunktion für den differenzierenden Eingangswandler und gleichzeitig eine Schutzfunktion für den Eingangsbereich der Elektronik gegeben.

Das analoge Filter kann als aktives Filter mit Verstärker ausgebildet sein. Dadurch ist eine zusätzliche Pegelanpassung zwischen Eingangswandler und nachfolgender Elektronik möglich.

Bevorzugt ist das analoge Filter ein Tiefpaß. Auf diese Weise sind speziell Spannungsspitzen, die insbesondere bei Phasenanschnitt entstehen und eine höhere Frequenz als die Netzfrequenz haben, begrenzt.

Mit Vorteil ist das analoge Filter als RC-Glied ausgeführt. Damit ist eine besonders einfache Ausgestaltung des Filters gegeben, die sich auch kostengünstig realisieren läßt. Die verwendeten Bauteile müssen dabei auch nicht solch hohen Anforderungen genügen, wie z.B. der Integrationskondensator bei einer Schaltung nach dem Stand der Technik.

Das analoge Filter kann ein Begrenzungsfilter zweiter oder höherer Ordnung sein. Auf diese Weise ist der Einfluß auf niedrige Frequenzen sehr gering. Eine Drift der verwendeten Kondensatoren hat nahezu keine Auswirkungen auf den Winkelfehler.

Bevorzugt ist der Analog/Digitalwandler ein Sigma-Delta-Wandler ($\Sigma\Delta$-Wandler). Auf diese Weise ist eine präzise und schnelle Wandlung der Eingangssignale möglich, wobei auch höchsten Anforderungen, z.B. bei Präzisionszählern, genügt werden kann.

In einer speziellen Ausgestaltung ist zwischen den analogen Filtern und dem Analog/Digitalwandler ein Multipexer geschaltet. Auf diese Weise können mit einem einzigen Analog/Digitalwandler mehrere Eingangssignale verarbeitet werden, wobei jeder dabei gebildete Kanal mit seinem Filter an die jeweiligen Signalverhältnisse angepaßt ist.

Bevorzugt weist der Elektrizitätszähler zumindest drei Eingangswandler zur Erfassung eines dreiphasigen Eingangssignals auf. Damit ist ein Einsatz in Drehstromnetzen möglich. Die Einrichtung weist mit Vorteil einen digitalen Signalprozessor auf. Dadurch ist eine einfache Realisierung der Filter- und Integrierfunktion möglich.

Bevorzugt ist das differenzierte Signal als Stromsignal ausgebildet. Der Einrichtung kann auch zusätzlich zumindest ein digitalisiertes Spannungssignal eines Spannungswandlers zugeführt sein, dem ebenfalls ein analoges Filter nachgeschaltet ist, und wobei in der Einrichtung das Spannungssignal auf das digitale Filter oder auf ein weiteres digitales Filter geführt ist. Auf diese Weise kann der Kompensationsalgorithmus im digitalen Filter sehr einfach ausgestaltet werden.

Diese Ausführung betrifft eine Anwendung, bei der Strom und Spannung, z.B. bei einer Leistungsmessung, miteinander verknüpft werden. Durch das analoge Filter bei der Stromerfassung findet eine Phasenverschiebung statt, die im digitalen Filter berücksichtigt werden muß. Tritt jedoch die gleiche Phasenverschiebung für das Spannungssignal auf, so kann auf die Phasenverschiebung im digitalen Filter verzichtet werden. Das digitale Filter muß das analoge Filter nur noch nach dem Betrag kompensieren. Die Spannungserfassung erfolgt selbstverständlich bevorzugt dreiphasig mit drei Spannungswandlern, wobei gegebenenfalls auch ein Nullstrom erfaßt werden kann.

Für die Spannungserfassung kann auch ein zusätzlicher Analog-Digital-Wandler, gegebenenfalls mit vorgeschaltetem Multiplexer, vorgesehen sein. Dadurch ist eine getrennte Signalerfassung für Strom und Spannung gegeben.

Die Erfindung,weitere Details und Vorteile werden nachfolgend anhand von Ausführungsbeispielen und der Zeichnung beispielhaft näher erläutert. Es zeigen:

FIG 1          einen Elektrizitätszähler mit analogen Filtern,

FIG 2          einen zweiten Elektrizitätszähler mit analogen Filtern zweiter Ordnung,

FIG 3          einen dritten Elektrizitätszähler mit Pegelanpassung und Impedanzwandlung und

FIG 4          einen vierten Elektrizitätszähler mit analogen Filtern in seiner Spannungserfassung.

In den nachfolgend beschriebenen Figuren sind gleiche oder gleichwirkende Details mit gleichen Bezugszeichen versehen, wobei gegebenenfalls Unterscheidungen zwischen gleichen Details unterschiedlicher Kanäle durch entsprechende Indizies oder zusätzliche nachgestellte Zeichen gekennzeichnet sind.

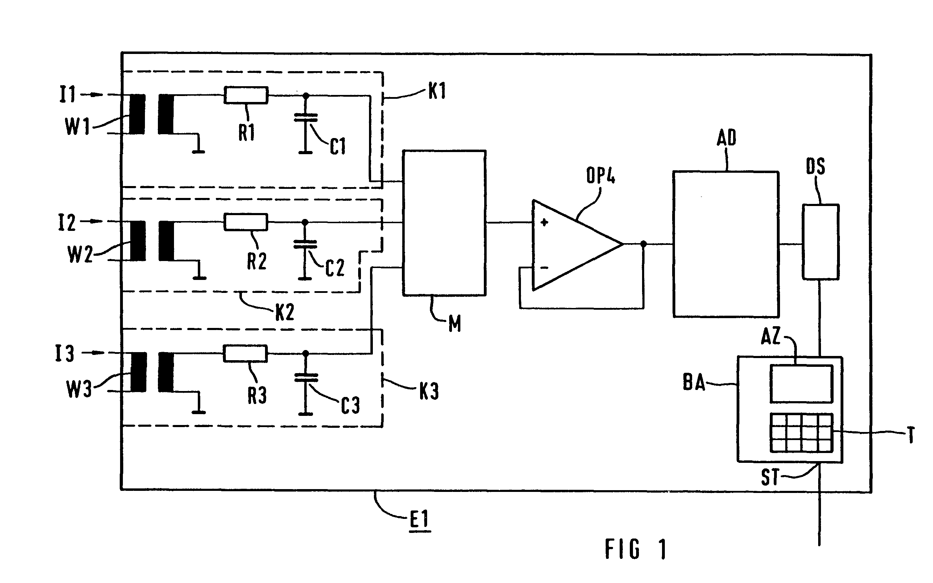

In FIG 1 ist ein Eingangskreis eines Elektrizitätszählers E1 im Detail gezeigt. Er weist drei Kanäle K1,K2,K3 auf, denen jeweils eines der Stromsignale I1,I2,I3 eines nicht näher gezeigten elektrischen Verbrauchers als Eingangssignale zugeführt ist. Im folgenden wird beispielhaft für alle Kanäle der Kanal K1 für jeweils jede Figur näher beschrieben.

Das Stromsignal I1 ist zunächst einem differenzierenden Wandler W1 des Kanals K1 zugeführt. Diesem nachgeschaltet ist ein analoges Filter, das von einem RC-Glied mit einem Widerstand R1 und einem Kondensator C1 gebildet ist.

Dieses Filter dient dazu, die am Ausgang des Wandlers W1 auftretenden Spannungsspitzen, die bis zu mehreren 100 Volt reichen können und von sehr kurzer Impulsdauer sind, zu begrenzen. Derartige Spannungsspitzen treten verstärkt in elektrischen Netzen auf, bei denen Phasenanschnittsteuerungen verwendet werden. Dort tritt nämlich eine große Änderung des Stromes in kurzer Zeit auf. Diese Spannungsspitzen sind deutlich höher als der einngangsseitige Spannungsbereich der nachgeschalteten Elektronik, insbesondere des folgenden Analog/Digitalwandlers (nachfolgend Wandler AD genannt) und können Spannungswerte bis zu mehreren 100 Volt erreichen. Ein bloßes Abschneiden dieser Spannungspitzen hätte zur Folge, daß eine unzulässig große Verfälschung des Meßsignals bei der nachfolgenden Integration stattfinden würde. Dies würde bei einer Leistungs- oder Energiemessung zu einen Meßfehler führen.

Die Kanäle K1,K2,K3 sind auf einen gemeinsamen Multiplexer M geschaltet, dessen Ausgangssignal über einen Operationsverstärker OP4 mit Gegenkopplung auf den Wandler AD geführt ist. Der Ausgang 4 des Wandlers AD ist auf eine Einrichtung DS zur digitalen Signalverarbeitung geführt, die eine datentechnische Bearbeitung der digitalisierten Stromsignale I1 bis I3 durchführt. Bei dieser Bearbeitung kann beispielsweise eine Verbrauchszählung, eine Fehlerüberwachung oder sonstige für Schutz oder Zählung wesentliche Funktionen erfüllt werden. Es ist selbstverständlich, daß für eine Berechnung von Leistung oder Arbeit der Einrichtung DS auch zusätzliche Spannungssignale des jeweiligen Verbrauchers über nicht näher dargestellte Kanäle zugeführt werden. Die digitale Einrichtung DS kann beispielsweise als digitaler Signalprozessor oder als Recheneinrichtung mit Mikroprozessor ausgebildet sein.

Der Einrichtung DS ist eine Bedien- und Anzeigeeinrichtung BA nachgeschaltet, die Mittel zur Bedienung, z.B. eine Tastatur T und Anzeigemittel AZ, umfaßt. Weiterhin kann die Bedien- und Anzeigeanordnung BA auch eine Schnittstelle ST aufweisen, die zum Datenaustausch, z.B. mit einem Handterminal oder einer übergeordneten leittechnischen Einrichtungen zur Fernabfrage, dient.

In der Einrichtung DS ist eine Integrationsfunktion durch ein digitales Filter realisiert. Diese Integrationsfunktion dient zur Kompensation des differenzierenden Einflusses der Eingangswandler W1,W2,W3.

Die analogen Filter begrenzen die jeweiligen Impulse oder Signale und verbreitern diese gleichzeitig. Es erfolgt also eine Signalverfälschung in Abhängigkeit von der Frequenz in Größe/Betrag und Winkel. Diese Verfälschung wird in der Einrichtung DS mit Hilfe eines zusätzlichen digitalen Filters kompensiert. Dieses zusätzliche digitale Filter weist eine inverse Übertragungsfunktion zu der der analogen Filter auf. Auf diese Weise ist der Einfluß der Filter auf die Übertragungsfunktion im unteren Frequenzbereich im wesentlichen beseitigt.

Die Übertragungsfunktion der analogen Filter lautet:

$$A(\omega) = \frac{1}{1 + j\omega RC}$$

Eine Nachbildung eines RC-Gliedes als digitales Filter liefert mit Hilfe einer bilinearen Transformation die folgende Übertragungsfunktion für den Z-Bereich:

$$A(z) = \frac{\alpha_0}{1 - \beta_1 \, z^{-1}}$$

Zur Kompensation des analogen Filters mit dem digitalen Filter ist die inverse Übertragungsfuntion nötig:

$$B(z)=\frac{1-\beta_1 z^{-1}}{\alpha_0}$$

Da *A*(z) und *A*(ω) nur für sehr hohe Abtastraten übereinstimmen, muß mit Hilfe von Verzögerungsgliedern eine weitere Anpassung erfolgen. Das bedeutet, daß das zu realisierende Filter bevorzugt höherer Ordnung sein muß. Nachfolgend ist ein Beispiel für eine mögliche Übertragungsfunktion aufgeführt.

$$B(z) = \frac{1-\beta_1 z^{-1}-\beta_2 z^{-2}-\beta_3 z^{-3}-\beta_4 z^{-4}}{\alpha_0+\alpha_1 z^{-1}+\alpha_2 z^{-2}+\alpha_3 z^{-3}+\alpha_4 z^{-4}}$$

Darin bedeuten:

R       Widerstand
C       Kapazität
ω       Kreisfrequenz
α,β,z       Koeffizienten

Die Werte für die jeweiligen Koeffizienten können vom Fachmann nach den ihm bekannten Methoden vorgegeben werden.

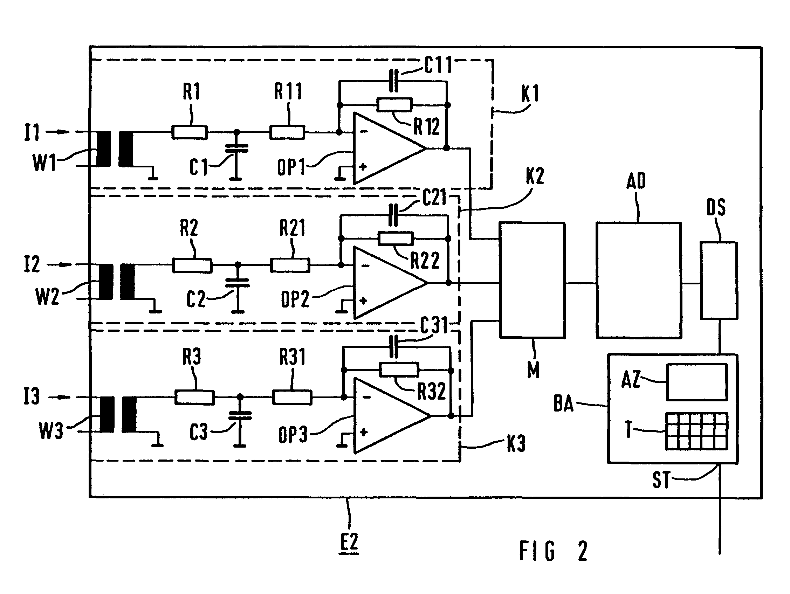

FIG 2 zeigt eine weitere Variante eines Elektrizitätszählers E2, der prinzipiell den gleichen Aufbau wie der Elektrizitätszähler E1 aus FIG 1 aufweist. Hier ist aus Vereinfachungsgründen auf den Operationsverstärker OP4 verzichtet.

Die Kanäle K1,K2,K3 weisen in dieser Ausführung als Filter ein Bandbegrenzungsfilter höherer Ordnung, insbesondere zweiter Ordnung, auf. Dazu ist dem Tiefpaß mit dem Widerstand R1 und dem Kondensator C1 ein Operationsverstärker OP1 mit einem Spannungsteiler bestehend aus den Widerständen R11 und R12 und einem Mitkopplungskondensator C11 nachgeschaltet. Auf diese Weise ist der Einfluß auf niedrige Frequenzen sehr gering. Die Drift der Kondensatoren, insbesondere des Kondensators C1, hat somit nur eine geringe Auswirkung auf den resultierenden Winkelfehler.

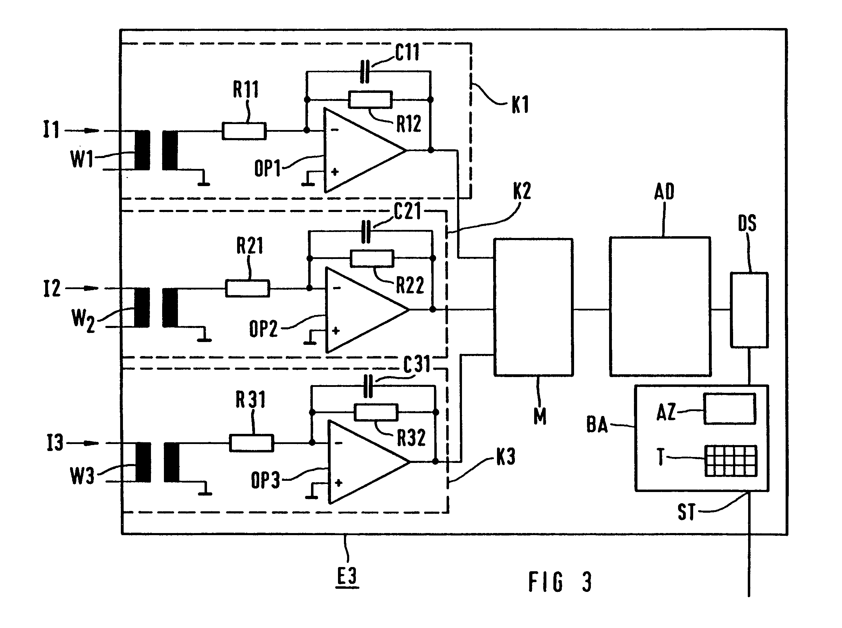

FIG 3 zeigt eine weitere Ausführung, die gegenüber der Ausführung gemäß FIG 2 einen vereinfachten Aufbau aufweist. Hier ist nämlich auf die Bauteile R1 und C1 verzichtet. Mit dieser Ausführung, die ein Filter erster Ordnung umfaßt, ist gegenüber der Ausführung gemäß FIG 1 eine Pegelanpassung und Impedanzwandlung möglich. Dies ist dadurch erzielt, daß das Filter ein aktives Bauteil, nämlich den Operationsverstärker OP1 als Verstärker umfaßt.

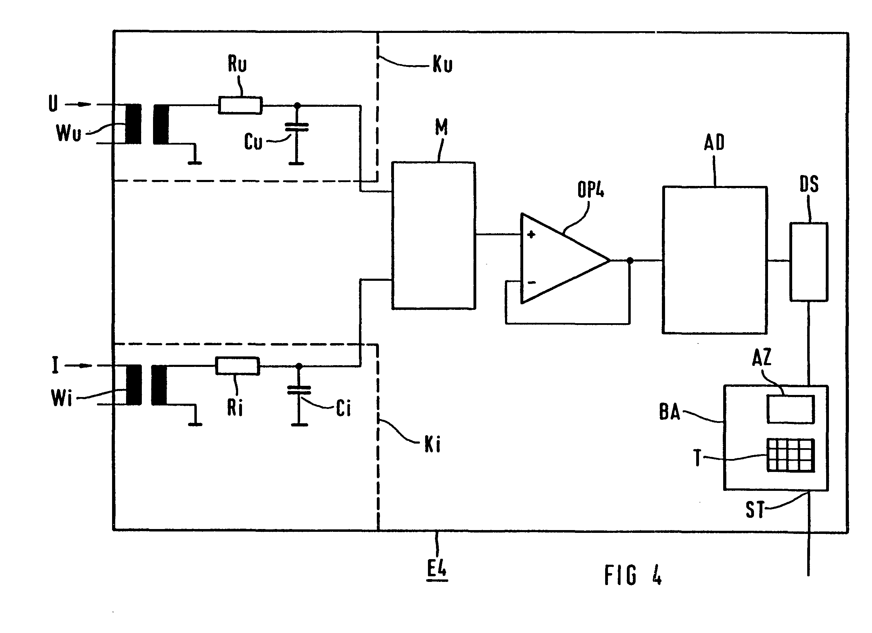

FIG 4 zeigt einen Elektrizitätszähler E4 gemäß der Ausführung E1 nach FIG 1, bei der zusätzlich Spannungssignale, z.B. für eine Energiemessung, verarbeitet werden. Aus Vereinfachungsgründen ist lediglich ein Spannungskanal Ku und ein Stromkanal Ki dargestellt, die auf einen gemeinsamen Multiplexer M geführt sind. Selbstverständlich ist auch hier eine getrennte Kanalbildung mit getrennten Multiplexern und Analog/Digitalwandlern bevorzugt. Beide Kanäle Kn und Ki weisen ein analoges Filter erster Ordnung auf.

Die analogen Filter sind derart ausgebildet, daß sie bei den jeweiligen Signalen die gleiche Phasenverschiebung verursachen. Dadurch braucht diese Signalverfälschung in der Einrichtung DS nicht berücksichtigt werden, wodurch Rechenzeit eingespart ist. Das digitale Filter zur Kompensation des/r analogen Filter/s muß nur dem Betrag nach kompensieren. Der Kompensationsalgorithmus ist also vereinfacht.

Bevorzugt findet für den Wandler AD ein ΣΔ-Modulator Verwendung. Dieser zeichnet sich durch günstige Eigenschaften für den Einsatz bei der Verbrauchsmessung aus, wobei durch Vorgabe bestimmter Parameter eine optimale Anpassung bezüglich Verarbeitungszeit und Genauigkeit an verschiedenste Signalverarbeitungen möglich ist. Andere Lösungen sind jedoch auch möglich.

## Patentansprüche

1. Elektrizitätszähler (E1,E2,E3,E4) mit zumindest einem differenzierenden Eingangswandler (W1,W2,W3), mit einem diesem bzw. diesen nachgeschalteten Analog/Digitalwandler (AD) und einer nachfolgenden Einrichtung (DS) zur digitalen Signalverarbeitung, wobei jeweils zwischen Eingangswandler (W1,W2,W3) und Analog/Digitalwandler (AD) ein analoges Filter geschaltet ist und die Einrichtung (DS) zur digitalen Signalverarbeitung ein digitales Filter aufweist,
**dadurch gekennzeichnet, daß** mit dem digitalen Filter eine Integration eines zuvor im Eingangswandler differenzierten und danach analog gefilterten und digitalisierten Signals erfolgt, und daß die Übertragungsfunktion des digitalen Filters invers zu der des analogen Filters ist.

2. Elektrizitätszähler nach Anspruch 1, wobei das analoge Filter als aktives Filter mit Verstärker (OP1 bis OP4) ausgebildet ist.

3. Elektrizitätszähler nach Anspruch 1 oder 2, wobei das analoge Filter ein Tiefpaß ist.

4. Elektrizitätszähler nach Anspruch 3, wobei das analoge Filter ein RC-Glied umfaßt.

5. Elektrizitätszähler nach einem der Ansprüche 1 bis 4, wobei das analoge Filter ein Begrenzungsfilter zweiter oder höherer Ordnung ist.

6. Elektrizitätszähler nach einem der Anspruche 1 bis 5, wobei der Analog/Digitalwandler (AD) ein Sigma-Delta-Wandler ist.

**7.** Elektrizitätszähler nach einem der Ansprüche 1 bis 6, wobei zumindest drei Eingangswandler (W1,W2,W3) mit jeweils zugeordneten analogen Filtern zur Erfassung eines dreiphasigen Eingangssignals vorhanden sind.

**8.** Elektrizitätszähler nach Anspruch 7, wobei zwischen den analogen Filtern und dem Analog/Digitalwandler (AD) ein Multiplexer (M) geschaltet ist.

**9.** Elektrizitätszähler nach einem der Ansprüche 1 bis 8, wobei die Einrichtung (DS) zur digitalen Signalverarbeitung einen digitalen Signalprozessor umfaßt.

**10.** Elektrizitätszähler nach einem der Ansprüche 1 bis 9, wobei das differenzierte Signal ein Abbild eines Stromsignals ist.

**11.** Elektrizitätszähler nach einem der Ansprüche 1 bis 10, wobei der Einrichtung (DS) zur digitalen Signalverarbeitung zusätzlich zumindest ein digitalisiertes Spannungssignal (U) eines Spannungswandlers (Wu) zugeführt ist, dem ebenfalls ein analoges Filter nachgeschaltet ist, und wobei in der Einrichtung (DS) zur digitalen Signalverarbeitung das Spannungssignal (U) auf das digitale Filter oder auf ein weiteres digitales Filter geführt ist.

**12.** Elektrizitätszähler nach Anspruch 11, wobei die Spannungserfassung dreiphasig ist, wozu drei Spannungswandler (Wu) vorhanden sind.

**13.** Elektrizitätszähler nach Anspruch 11 oder 12, wobei für die Spannungserfassung ein zusätzlicher Analog/Digitalwandler, gegebenenfalls mit vorgeschaltetem Multiplexer, vorhanden ist.

**Claims**

**1.** Electricity meter (E1/E2/E3,E4) having at least one differentiating input converter (W1,W2,W3), having an analog/digital converter (AD), connected downstream of the input converter(s), and a device (DS) arranged downstream of the analog/digital converter (AD) for digital signal processing, with a respective analog filter being connected, in each case, between the input converter (W1,W2,W3) and the analog/digital converter (AD), and the device (DS) for digital signal processing having a digital filter, **characterized in that** integration of a signal, which was previously differentiated in the input converter and was subsequently analog filtered and digitized, is effected by means of the digital filter, and **in that** the transfer function of the digital filter is inverse to that of the analog filter.

**2.** Electricity meter according to claim 1, wherein the analog filter is formed as an active filter with an amplifier (OP1 to OP4).

**3.** Electricity meter according to claim 1 or 2, wherein the analog filter is a low-pass filter.

**4.** Electricity meter according to claim 3, wherein the analog filter comprises an RC element.

**5.** Electricity meter according to one of claims 1 to 4, wherein the analog filter is a second-order or a higher-order limiting filter.

**6.** Electricity meter according to one of claims 1 to 5, wherein the analog/digital converter (AD) is a sigma-delta converter.

**7.** Electricity meter according to one of claims 1 to 6, wherein at least three input converters (W1,W2,W3) each having associated analog filters are provided for the detection of a three-phase input signal.

**8.** Electricity meter according to claim 7, wherein a multiplexer (M) is connected between the analog filters and the analog/digital converter (AD).

**9.** Electricity meter according to one of claims 1 to 8, wherein the device (DS) for digital signal processing comprises a digital signal processor.

**10.** Electricity meter according to one of claims 1 to 9, wherein the differentiated signal is a duplicate of a current signal.

**11.** Electricity meter according to one of claims 1 to 10, wherein there is additionally fed to the device (DS) for digital signal processing at least one digitized voltage signal (U) of a voltage converter (Wu), connected downstream of which there is likewise an analog filter, and wherein in the device (DS) for digital signal processing the voltage signal (U) is carried to the digital filter or to a further digital filter.

**12.** Electricity meter according to claim 11, wherein the voltage detection is three-phase detection, provided for which there are three voltage converters (Wu).

**13.** Electricity meter according to claim 11 or 12, wherein an additional analog/digital converter, if applicable with a multiplexer connected upstream thereof, is provided for the voltage detection.

**Revendications**

1. Compteur (E1, E2, E3, E4) comportant au moins un convertisseur (W1, W2, W3) d'entrée différentiateur, comportant un convertisseur (AD) analogique/numérique en aval de celui-ci ou de ceux-ci et un dispositif (DS) en aval pour le traitement numérique des signaux, un filtre analogique étant branché chaque fois entre les convertisseurs (W1, W2, W3) d'entrée et le convertisseur (AD) analogique/numérique et le dispositif (DS) pour le traitement numérique des signaux comportant un filtre numérique, **caractérisé en ce qu'**il s'effectue par le filtre numérique une intégration d'un signal différencié précédemment dans le convertisseur d'entrée et ensuite filtré de manière analogique et numérisé et **en ce que** la fonction de transfert du filtre numérique est inverse par rapport à celle du filtre analogique.

2. Compteur électrique suivant la revendication 1, le filtre analogique étant réalisé en filtre actif à amplificateur (OP1 à OP4).

3. Compteur électrique suivant la revendication 1 ou 2, le filtre analogique étant un passe-bas.

4. Compteur électrique suivant la revendication 3, le filtre analogique comportant un élément RC.

5. Compteur électrique suivant l'une des revendications 1 à 4, le filtre analogique étant un filtre limitateur de deuxième ordre ou d'un ordre supérieur.

6. Compteur électrique suivant l'une des revendications 1 à 5, le convertisseur (AD) analogique/numérique étant un convertisseur sigma-delta.

7. Compteur électrique suivant l'une des revendications 1 à 6, au moins trois convertisseurs (W1, W2, W3) d'entrée comportant chacun des filtres analogiques associés étant présents pour la détection d'un signal d'entrée triphasé.

8. Compteur électrique suivant la revendication 7, un multiplexeur (M) étant branché entre les filtres analogiques et le convertisseur (AD) analogique/numérique.

9. Compteur électrique suivant l'une des revendications 1 à 8, le dispositif (DS) pour le traitement numérique des signaux comportant un processeur de signaux numérique.

10. Compteur électrique suivant l'une des revendications 1 à 9, le signal différentié étant une représentation d'un signal de courant.

11. Compteur électrique suivant l'une des revendications 1 à 10, étant envoyé au dispositif (DS) pour le traitement numérique de signaux de plus au moins un signal (U) de tension numérisé d'un convertisseur (Wu) de tension en aval duquel est monté également un filtre analogique, et le signal (U) de tension étant, dans le dispositif (DS) pour le traitement numérique de signaux, envoyé au filtre numérique ou à un filtre numérique supplémentaire.

12. Compteur électrique suivant la revendication 11, la détection de tension étant triphasée, trois convertisseurs (Wu) de tension étant présents à cet effet.

13. Compteur électrique suivant la revendication 11 ou 12, un convertisseur analogique/numérique supplémentaire, comportant le cas échéant un multiplexeur en amont, étant présent pour la détection de tension.

FIG 1

FIG 2

FIG 3

FIG 4